# EUROPEAN PATENT APPLICATION

(11) **EP 1 111 730 A2**
(43) Date of publication of application: **27.06.2001**
(21) Application number: 00128094.0
(22) Date of filing: 21.12.2000
(51) Int. Cl.: H01R 13/648

(54) **Electrical connector assembly with screen and ESD protection**

(30) Priority: 23.12.1999 DE 20022723 U
(71) Applicant: MOLEX INCORPORATED, Lisle Illinois 60532 (US)
(72) Inventor: Schempp, Otto, 74906 Bad Rappenau (DE); Fasold, Michael, 71397 Lautenbach (DE)
(74) Representative: Herden, Andreas F.

(57) **Abstract**

The invention relates to an electrical connector assembly having an electrostatic discharge device (31), a screen (25) for an electrical connector assembly with an electrical discharge device (31) and relates to an electrical discharge device (31) itself. A device (31) for discharging electrostatic charges comprises according to the invention a resilient, electrically conductive material and is apt to ensure a discharge of electrostatic charges on a reliable basis and with severely reduced space requirements.

## Description

The invention relates in general to shielded electrical connectors and especially to an electrical connector assembly having an electrostatic discharge device protecting against electrostatic discharges, to a screen for an electrical connector assembly with an electrical discharge device and also relates to an electrical discharge device.

Electrical connector assemblies provide access to electrical and electronic circuits connected downstream to a power or signal path. However, in case of connecting two or more electronic devices, for example in electronic in-house networks or Intranets, firstly considerable electrical potential differences or voltages may occur between the individual devices and, secondly, in case of electrical potential-free connections, electrostatic charges can be applied and when the associated electrical connectors are joined together, undesired discharge of the charges producing the potential difference, or discharging of the electrostatic charge, may occur. These discharging processes are apt to cause severe damage in electronic equipment arranged downstream the signal or power path, it being possible for the damage even to lead to complete failure of the respective equipment.

US-A 5,947,773 describes an electrical connector with an electrostatic discharge protection (ESD Protection), in which, in addition to the terminals of the connector, pairs of discharge contacts arranged in front of the said terminals are connected with a defined resistance to the ground potential of the electrical equipment. A disadvantage of this assembly is that, as a result of the additional pairs of terminals, further capacitances and resistances are coupled to the signal path. This, under certain circumstances causes a considerable detrimental influence on the high-frequency transmission characteristics of the electrical connector. In addition, introducing further pairs of electrical terminals leads to a significant enlargement of the dielectric housing of the connector, which is in contradiction to the continuous efforts for a further miniaturization.

Consequently, it is an object of the invention to ameliorate the above-described disadvantages and, in particular, to provide an electrical connector assembly and a device for screening an electrical connector assembly in which a discharge of electrostatic charges is permanently reliable and is possible with a small space requirement.

This object is obtained in a surprisingly simple manner by an electrical connector assembly comprising a dielectric housing, terminals which are held in the dielectric housing and comprise connecting portions to provide electrical contact to terminals of an associated electrical connector, the terminals also comprising connecting ends for establishing an electrical connection to electrical feed lines, a device for discharging electrostatic charges, with the device for discharging electrostatic charges comprising a resilient, electrically conductive material.

The inventors found out that, by means of a resilient conductive material, the terminals of an associated electrical connector can reliably discharged, especially electrostatic charge can be removed before these terminals come into contact with the terminal portions of the other connector.

It has proven to be advantageous to arrange the device for discharging electrostatic charges close to an insertion opening of the dielectric housing, in insertion direction in front of the connecting portions of the electrical connector.

When RJ 45 connectors are used, a comb-like portion of the resilient material provides great advantages since a considerably enlarged surface area of the terminals of the associated connector to be inserted can be gripped by its teeth and, moreover, in addition to the electrostatic discharge, a considerable cleaning action is provided.

If the comb-like portions of the electrostatic discharge device project laterally into an insertion cavity formed in the dielectric housing of the electrical connector for an associated mating electrical connector, then the associated electrical connector undergoes a forced discharge as it is inserted, and it is possible for the resilient, electrically conductive material both to be forced back by means of volume compression and to be bent back resiliently. Such a design of the electrostatic discharge device means that the latter can be used without significant enlargement of the dimensions of the housing, for example in a socket-type RJ 45 connector, in which a front recessed housing accommodates the resilient conductive material.

By using a ramp-like area formed behind the comb-like portion of the dielectric housing and extending obliquely with respect to the insertion direction, the conductive material can be prevented from shearing off, since by this means the comb-like portion is enabled to be bend back, even essentially without any volume compression.

In a further advantageous refinement, the electrostatic discharge device comprises fastening means which are adapted to interact with fastening means of the dielectric housing and can hold the electrostatic discharge device in its position.

If the fastening means comprise recesses and protrusions, and if the recesses are formed by the resilient material and are somewhat smaller than the protrusions, this means that holding forces can already be provided which are suitable for holding the electrostatic discharge device permanently on the dielectric housing.

With a screen which surrounds at least a front area of the dielectric housing and is in electrical contact with the electrostatic discharge device, the latter can be kept in a simple way at the electrical potential of the housing of the respective electrical or electronic device.

A particularly preferred embodiment comprises a multiple connector assembly which comprises a large number of cavities for associated electrical connectors, and in which the connecting portions of the terminals for the associated electrical connectors are arranged in each case in two cavities adjoining in pairs on that inner side of the cavity which is closest to the respectively paired adjacent cavity.

This makes it possible, in particular, to arrange the device for discharging electrostatic charges between two paired adjacent cavities in each case and to use a single device for both cavities.

A preferred embodiment of the device for discharging electrostatic charges comprises a resilient, electrically conductive material with an essentially T-shaped cross section, in which the comb-like portions each point away from one another and in which the central portion rests at the end on the screen in such a way that this produces a mechanical bias or prestress which then contributes to holding the resilient conductive material in its position.

In a further preferred embodiment, the screen for the electrical connector assembly comprises a metal sheet, in which insertion openings for associated cavities of the dielectric housing of the electrical connector are defined, and on which a resilient conductive material is arranged.

In a particularly preferred further refinement, comb-like portions of the electrostatic discharge device extend somewhat into the insertion openings in such a way that this results in a forced discharge occurring during the insertion operation. In addition, given a defined lateral projection of the resilient material on all sides, a sealing and vibration-inhibiting action can be implemented, which protects circuits in a rough environment, such as PCMCIA board adapters or connectors arranged in lap-top housings, when the associated male connector is inserted.

If the screen is produced as a retrofitting set for electrical connector assemblies, the electrically conductive resilient material of a preferred embodiment advantageously consists of a stamped sheet, which is already fastened to the metal sheet with a conductive adhesive. This provides a unit which can be treated and handled on its own and which, together with the screen, has an electrostatic protective function.

The invention is described in more detail below with reference to the appended drawings and on the basis of preferred embodiments.

In the drawings:
- Fig. 1: shows a front view of the housing of a multiple connector assembly according to an embodiment of the invention,
- Fig. 2: shows a perspective sectional illustration, obliquely from the front, along the section plane A-A shown in Fig. 1,
- Fig. 3: shows a side view of the perspective sectional illustration from Fig. 2 in the direction of arrow B shown in Fig. 2,
- Fig. 4: shows an enlarged detail of the side view from Fig. 2,
- Fig. 5: shows a perspective sectional illustration of a detail from Fig. 3, which shows part of the screen and the electrostatic discharge device,
- Fig. 6: shows an enlarged detail of a side view corresponding to Fig. 2 in a further embodiment according to the invention,
- Fig. 7: shows an enlarged detail of a side view of a cross section similar to Fig. 6 in yet another embodiment according to the invention in the form of a single connector assembly without fitted screen, and
- Fig. 8: shows the embodiment of the single connector assembly illustrated in Fig. 7 with fitted screen.

### Detailed Description of preferred Embodiments

The invention is described in more detail below and in view of preferred embodiments. In order to support a better understanding, in the description of the respective embodiments, identical reference symbols are used for identical or similar parts or subassemblies.

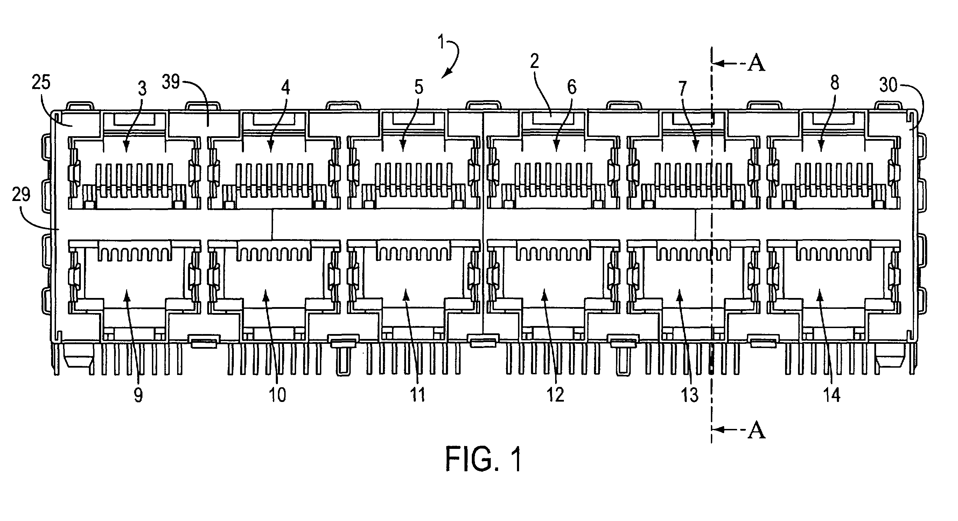

Reference is made first to Figure 1, which shows a front view of an electrical multiple connector assembly 1, which comprises twelve socket-like RJ 45 connectors 3 to 14 in one dielectric housing 2 and depicts a first preferred embodiment of the invention.

Although the invention will be described below in view of an embodiment using multiple connectors and in particular using socket-like RJ 45 connectors, it is not restricted to this special type of connector.

RJ 45 multiple connector assemblies of this type, without a device according to the invention for discharging electrostatic charges, are described in more detail, for example in the German Utility Model DE 298 19 341.0 from the same applicant, and the disclosure of this German Utility Model DE 298 19 341.0 in its entirety is also incorporated by reference into the description of the present disclosure of the invention.

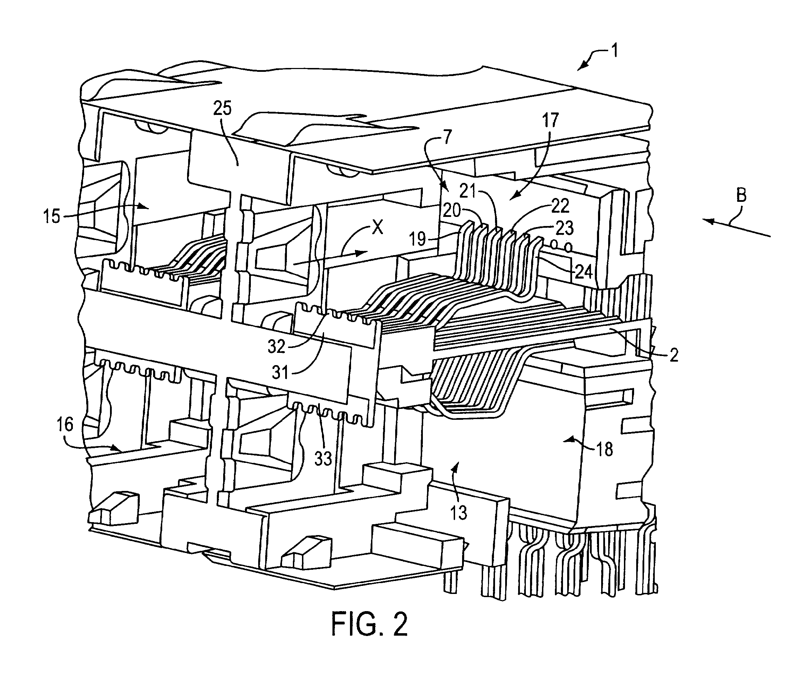

Formed in the dielectric housing 2, for each socket-like RJ 45 connector in each case, is a cavity 15 to 18 to accommodate an RJ 45 connector, which will be described in more detail below with reference to Figure 2 and cavity 17.

Into each of the cavities extend eight terminals in each case, of which in Figure 2, because of the cross sectional plane chosen, only six terminals 19 to 24 can be seen, each being held in the dielectric housing 2.

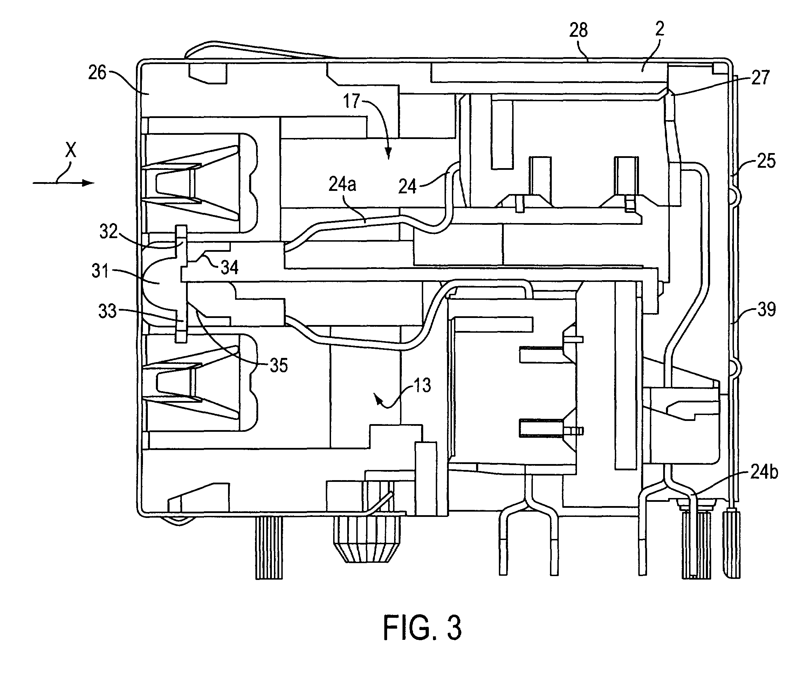

In addition, Figure 3 reveals, using the example of terminal 24, that the terminal 24 forms a connecting portion 24a to provide an electrical contact with the terminals of an associated mating electrical connector well known to a person skilled in the art and, therefore, not shown in the drawings. In this case, the connecting portions for the associated electrical connector of two adjacent cavities 13, 17 are each arranged in front of that inner side of cavity 13 which is closest to adjacent cavity 17.

When an associated mating RJ 45 connector is inserted, the connecting portion 24a will come into contact with the terminals of the associated RJ 45 connector and in this way produce an electrical connection.

Terminal 24 further comprises a connecting end 24b for an electrical connection to electrical feed lines, for example an electric printed circuit board or solder tabs for the connection of flexible flat conductor tracks or similar circuitry.

Dielectric housing 2 is surrounded by a screen 25 which, in the form of a metal sheet 39, extends essentially parallel and closely adjacent to the outer surface of the front side 26, the rear side 27, the top side 28 and side walls 29 and 30 (see Figures 1 and 3).

In opposite insertion direction, i.e. in a direction opposite to arrows X illustrated in Figures 2 and 3, a device for discharging electrostatic charges 31 is in each case arranged in front of the terminals 19 to 24, and comprises a resilient, electrically conductive material. The resilient, electrically conductive materials used according to the invention may be, in particular, all elastomers, thermoplastics or further resilient materials or any combinations thereof which exhibit a specific electrical conductivity which is suitable for carrying at least low current intensities. It is generally possible to use conductivities in the range from a few Ohm/cm to several MOhm/cm.

Conductivity sufficient for the resilient material according to the present invention also can be provided by means of incorporated conductive grains, by means of doping or by means of an intrinsic conductivity of the resilient material itself. In the case of foam, cellular or sponge-like material, conductivity also can be provided by means of a surface coating with a conductive substance.

As Figure 2 shows in more detail, the device 31 for discharging electrostatic charges has, for each of the cavities 13, 17, a comb-like portion 32, 33 which, in each case behind the insertion opening, projects into cavity 13, 17 formed by the dielectric housing and is in each case arranged between two paired adjacent cavities 13, 17.

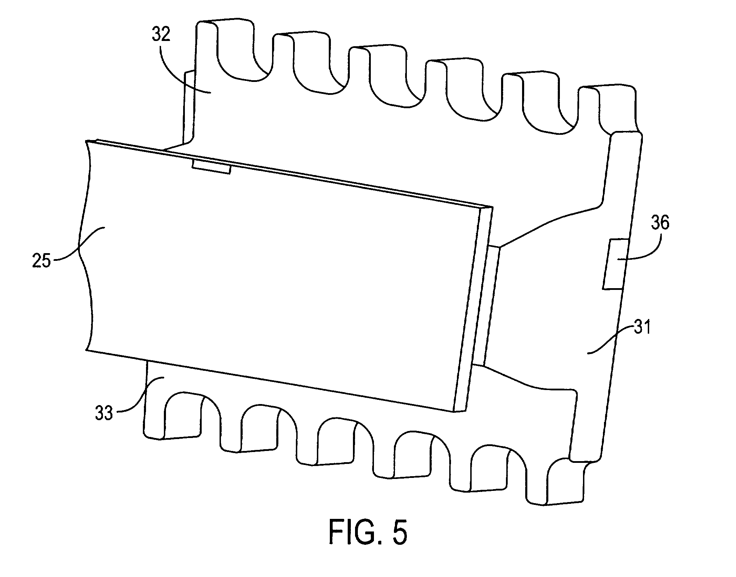

Device 31 for discharging electrostatic charges has, in the first preferred embodiment, an essentially T-shaped cross section in which comb-like portions 32, 33 each point away from one another and in which the central section rests, at the end, on the screen 25 and thus produces an electrical contact with the potential of the screen 25 (see also Figure 5).

The teeth of the comb-like portion 32, 33 have a width which essentially corresponds to the spacing or pitch of the connecting portions of the terminals 19 to 14 in the dielectric housing 2, and therefore corresponds to the spacing of the terminals of the associated electrical connector, so that when the associated electrical connector is inserted, a large-area contact is produced between the resilient material and the terminals of the associated mating connector.

Behind comb-like portion 32, 33, a ramp-like area extending obliquely with respect to the insertion direction X is defined by the dielectric housing and, when the associated electrical connector is inserted, permits resilient bending of the comb-like areas 32, 33 in the insertion direction X, without it being possible for any parts of the resilient, electrically conductive material to be sheared off.

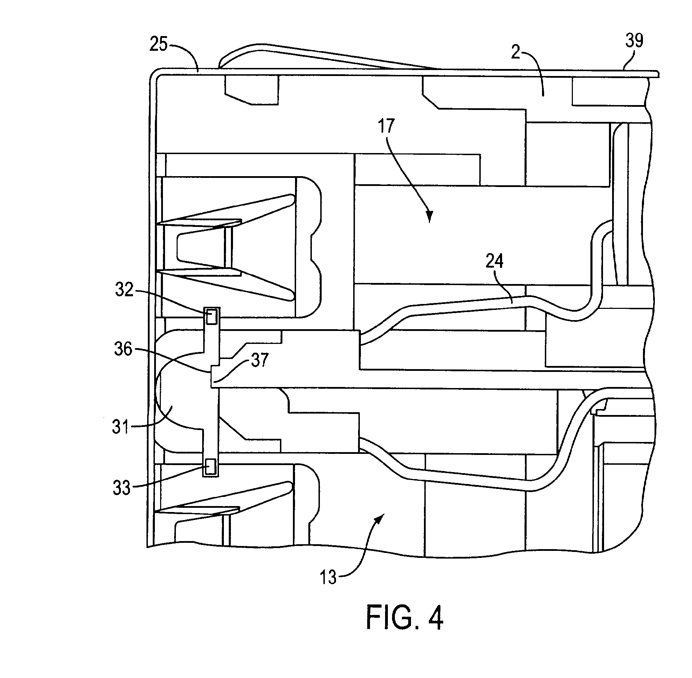

The enlarged illustration of Figure 4 reveals that the electrostatic discharge device 31 comprises fastening means 36 which interact with fastening means 37 of the dielectric housing 2 and hold the electrostatic discharge device 31 on dielectric housing 2.

Without restricting generality, fastening means 36 comprise recesses which are formed in the resilient material and protrusions 37 which extend forwards from the dielectric housing 2, i.e. in a direction opposite to that of arrows X from Figures 2 and 3. Since recesses 36 are formed by the resilient material and are smaller than protrusions 37, the protrusions held in the recesses can provide suitable holding forces, depending on the dimensions, on the size ratio and suitable choice of the resilient material. In addition, the scope of the invention includes fastening the resilient, electrically conductive material to the dielectric housing 2 with an adhesive.

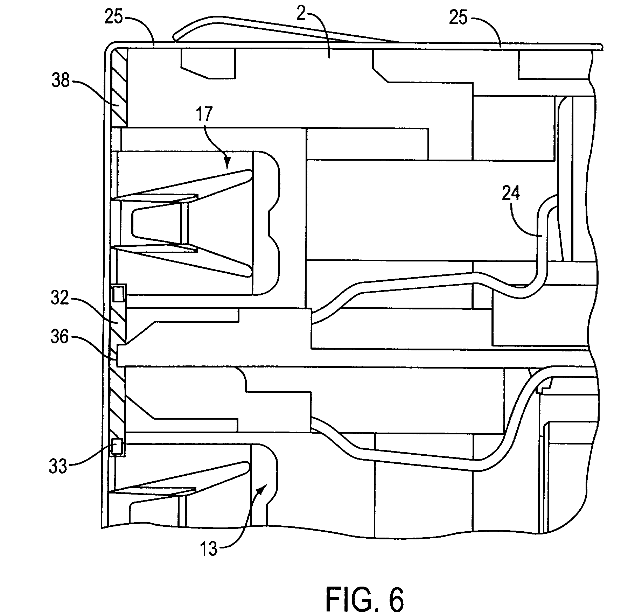

Now, reference is made to Figure 6, where a further embodiment according to the invention is illustrated, in which the electrostatic discharge device comprises a resilient, electrically conductive sheet 38 the two-dimensional extension of which, apart from the respective comb-like portions 32, 33, correspond to the area of the front side 26 of the dielectric housing 2 or the front side of the screen 25. In order to produce this geometry, sheet 38 can expediently be obtained, for example, by stamping it out from a carrier sheet.

Sheet 38 can also be fastened to screen 25 by means of a conductive adhesive, so that in this way a screen subassembly which can be handled on its own, with an electrostatic discharge device, is provided.

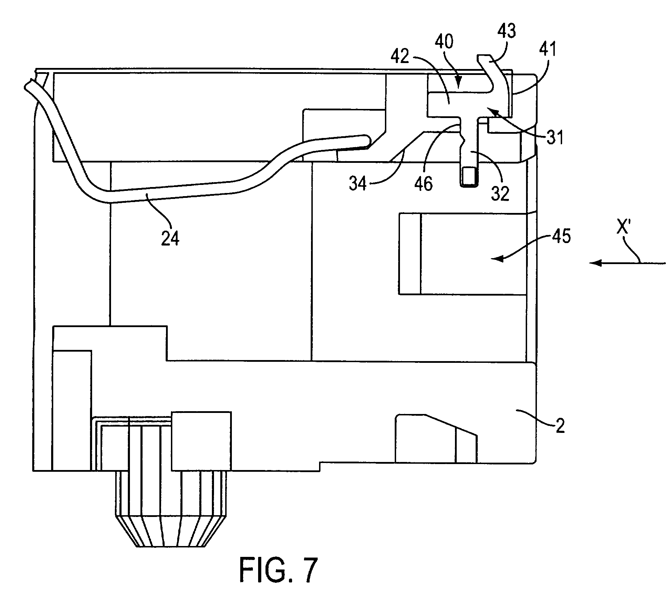

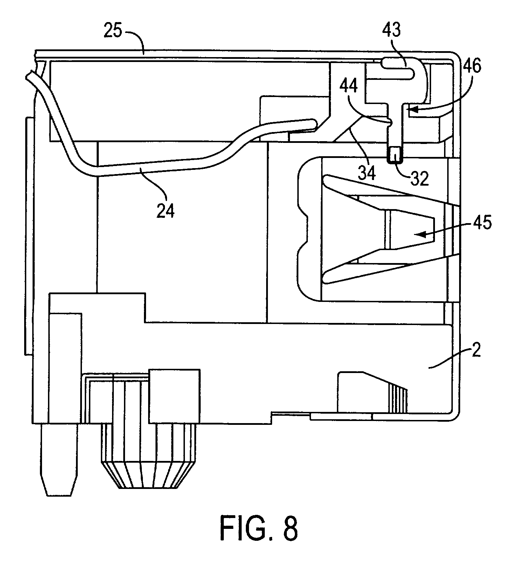

A further embodiment according to the invention is illustrated in Figures 7 and 8, to which reference is made below.

Figure 7 shows an enlarged detail of a side view of a cross section similar to the side view of Figure 6, but in yet another embodiment according to the invention. This further embodiment comprises a socket-like RJ 45 connector having only a single cavity 45 to accommodate an associated RJ 45 plug-in or male connector. In Figure 7, the connector assembly is illustrated without a screen, in order to be able to illustrate better the specific shape of the device 31 for discharging electrostatic charges.

In this embodiment, the device 31 for discharging electrostatic charges is arranged in a passage opening 40 which leads to the interior of cavity 45. This passage opening 40 defines an essentially rectangular cup-like area 41, at the bottom of which a passage 46 to the interior of the cavity 45 is formed.

The resilient material of the electrostatic discharge device 31 defines a widened area 42 the width of which essentially corresponds to the clear width of rectangular area 41 or is slightly greater than this. In the last-mentioned case, there is a deliberate press fit of the widened area 42 in the rectangular part 41 of the passage opening 40, which holds the device 31 securely in its defined installation position, for example during assembly.

Comb-like portion 32 of the electrostatic discharge device 31 extends from the widened area 42, through the passage 46, into the interior of cavity 45 and in this way reaches the terminals of an associated connector before these terminals get into the desired electrical contact with terminals 19 to 24.

Comb-like portion 32 has a recess 44 which reduces its tilting resistance locally and therefore ensures that defined tipping of the comb-like portion in the insertion direction, in the direction of arrow X into the ramp-like area 34 takes place when an associated RJ 45 plug-in or male connector is inserted into cavity 45.

Above the widened area 42, on the electrostatic discharge device 31, there is arranged an extension 43 which, in the undeformed state, projects beyond the passage opening 40, as illustrated in Figure 7.

In the following text, reference will be made to Figure 8, which shows the embodiment of the single connector assembly illustrated in Figure 7 with the screen 25 fitted or in ist finally assembled position.

When screen 25 is fitted or mounted, it comes into mechanical contact with the extension 43 and therefore, because of the conductivity of the resilient material of device 31, also comes into electrical contact with the said extension. The bending of the extension 43, together with its resilient restoring forces, leads to a vibration-proof and reliable permanent electrical connection between the screen 25, which is preferably at ground potential, and the comb-like portion 32.

## Claims

1. Electrical connector assembly comprising
a dielectric housing (2),
terminals (19 to 24) which are held in the dielectric housing (2) and comprise connecting portions (24a) adapted to provide electrical contact to terminals of an associated electrical connector, with said terminals (19 to 24) having connecting ends (24b) adapted to establish an electrical connection to electrical feed lines,
a device (31) for discharging electrostatic charges,
which is characterized in that
the device (31) for discharging electrostatic charges comprises a resilient, electrically conductive material.

2. Electrical connector assembly according to claim 1, characterized in that said device (31) for discharging electrostatic charges is arranged in the vicinity of an insertion opening of the dielectric housing (2), in the opposite insertion direction (X) in front of the connecting portions (24a) for the terminals of the associated connector.

3. Electrical connector assembly according to claim 1 or 2, characterized in that the device (31) for discharging electrostatic charges has a comb-like portion (32, 33) which projects into a cavity (15 to 18), formed behind the insertion opening of the dielectric housing (2), to accommodate the associated connector.

4. Electrical connector assembly according to claim 3, characterized in that teeth of the comb-like portion (32, 33) have a width which essentially corresponds to the spacing of the connecting portions of the terminals (19 to 24) in the dielectric housing (2).

5. Electrical connector assembly according to claim 3 or 4, characterized in that behind the comb-like portion (32, 33), a ramp-like area (34, 35) extending obliquely with respect to the insertion direction (X) is defined in the dielectric housing (2).

6. Electrical connector assembly according to one of claims 1 to 5, characterized in that the electrostatic discharge device (31) comprises fastening means (36) which interact with fastening means (37) of the dielectric housing (2) and hold the electrostatic discharge device (31).

7. Electrical connector assembly according to claim 6, characterized in that the fastening means (36, 37) comprise recesses and protrusions.

8. Electrical connector assembly according to claim 7, characterized in that the recesses (36) are formed from the resilient, electrically conductive material and are smaller than the protrusions (37), so that the protrusions (37) held in the recesses (36) provide holding forces.

9. Electrical connector assembly according to one of claims 1 to 8, further characterized by a screen (25) which surrounds at least a front area of the dielectric housing (2) and is in electrical contact with the electrostatic discharge device (31).

10. Electrical connector assembly according to one of claims 1 to 9, characterized in that the connector assembly (1) is a multiple connector assembly and has a plurality of cavities (15 to 18) for associated electrical connectors, in which the connecting portions (24) for the associated electrical connector of two adjacent cavities (17, 18) are arranged in front of the inner side of the cavity (17, 18) which is closest to the respective adjacent cavity (17, 18).

11. Electrical connector assembly according to claim 10, characterized in that the device (31) for discharging electrostatic charges is arranged between two adjacent cavities (17, 18).

12. Electrical connector assembly according to one of claims 1 to 11, characterized in that the device (31) for discharging electrostatic charges has an essentially T-shaped cross section in which the comb-like portions (32, 33) each point away from one another and the central portion rests, at the end, on the screen (25).

13. Electrical connector assembly according to one of claims 1, 3, 4 or 9, characterized in that the device (31) for discharging electrostatic charges is arranged in a passage opening (40) which leads to the interior of the cavity (15 to 18; 45).

14. Electrical connector assembly according to claim 13, characterized in that the passage opening (40) defines an essentially rectangular area (41) at the bottom of which a passage to the interior of the cavity (15 to 18; 45) is formed.

15. Electrical connector assembly according to claim 13 or 14, characterized in that the comb-like portion (32) of the electrostatic discharge device (31) extends through the passage (46).

16. Electrical connector assembly according to claim 13, 14 or 15, characterized in that the resilient material of the electrostatic discharge device (31) defines a widened area (42) a width of which essentially corresponds to the clear width of said rectangular area (41) or is slightly greater than the width of said rectangular area (41).

17. Electrical connector assembly according to one of claims 13 to 16, further characterized by an extension (43) which is arranged on the electrostatic discharge device (31), in its undeformed state projects beyond the passage opening (40) and, when said screen (25) is assembled, establishes electrical contact to said screen (25).

18. Electrical connector assembly according to one of claims 13 to 17, characterized in that the comb-like portion (32) defines a recess (44) which reduces its tilting resistance locally.

19. Screen for an electrical connector assembly, comprising an electrostatic discharge device (31).

20. Screen for an electrical connector assembly according to claim 19, characterized in that said electrostatic discharge device (31) comprises a resilient, electrically conductive material.

21. Screen for an electrical connector assembly according to claim 19 or 20, further characterized by insertion openings which are defined in a metal sheet (39) of the screen and are associated with cavities (15 to 18; 45) of the dielectric housing (2) of the electrical connector assembly (1), and in which comb-like portions (32, 33) of the device (31) for discharging electrostatic charges extend into the cross section of the insertion openings.

22. Screen for an electrical connector assembly according to claim 19, 20 or 21, characterized in that the resilient, electrically conductive material consists of a stamped sheet (38).

23. Screen for an electrical connector assembly according to one of claims 19 to 22, characterized in that the resilient, electrically conductive material (38) is fastened to the metal sheet (39) with a conductive adhesive.

24. Electrostatic discharge device for an electrical connector assembly, comprising a resilient, electrically conductive material.

25. Electrostatic discharge device for an electrical connector assembly according to claim 24, characterized in that the resilient, electrically conductive material comprises a sheet (38).

26. Electrostatic discharge device according to claim 24, characterized in that the resilient, electrically conductive sheet (38) forms insertion openings for associated cavities (15 to 18) of an electrical connector (1), into which cavities comb-like portions (32, 33) of the sheet (38) project.
